# FASCICULE DE BREVET EUROPEEN

(11) **EP 0 384 795 B1**
(45) Date de publication et mention de la délivrance du brevet: **04.08.1993**
(21) Numéro de dépôt: 90400235.9
(22) Date de dépôt: 26.01.1990
(51) Int. Cl.: H04L 25/49, H03M 5/14

(54) **Procédé et dispositif de transmission d'informations entre stations d'un réseau de communication, notamment pour véhicule automobile**
Verfahren und Vorrichtung zur Informationsübertragung zwischen Stationen eines Kommunikationsnetzwerkes, insbesondere für Kraftwagen
Method and device for transmitting information between stations of a communication network, especially for a motor vehicle

(30) Priorité: 22.02.1989 FR 8902307
(43) Date de publication de la demande: 29.08.1990
(73) Titulaire: AUTOMOBILES PEUGEOT, 75116 Paris (FR); AUTOMOBILES CITROEN, 92200 Neuilly-sur-Seine (FR)
(72) Inventeur: Abou, Bruno, F-75014 Paris (FR); Herbault, Patrick, F-75016 Paris (FR); Malville, Joel, F-60230 Chambly (FR)
(74) Mandataire: Polus, Camille

(56) Documents cités:
- DE-A- 3 526 052
- IBM TECHNICAL DISCLOSURE BULLETIN, vol. 28, no. 10, mars 1986, pages 4440-4441, New York, US; Group encoding method for infrared communication"
- PATENT ABSTRACTS OF JAPAN, vol. 10, no. 46 (E-383)[2103], 22 février 1986 & JP-A-60 199 258

## Description

La présente invention concerne un procédé et un dispositif de transmission d'informations entre stations d'un réseau de communication, notamment pour véhicule automobile.

Différents réseaux de communication, tels que ceux proposés notamment pour interconnecter des stations ou équipements électroniques d'un véhicule automobile, utilisent une méthode d'accès par arbitrage bit à bit. En particulier, on peut citer les protocoles de communication suivants :
- le protocole J 1850 (SAE)
- le protocole C²D (Chrysler)
- le protocole CAN (Bosch)

Cette méthode d'accès repose sur le fait que le bus physique des réseaux de transmission, peut avoir deux états distincts, et qu' en cas d'émission simultanée des deux états, l'un des états s'impose de façon systématique et est appelé état dominant.

L'autre état est dit récessif et correspond à l'état de bus libre.

Quand plusieurs stations veulent accéder en même temps au réseau, après s'être synchronisées sur un début de message, elles émettent en parallèle leur message respectif et s'arrêtent d'émettre dès qu'ayant émis un bit récessif, elles relisent sur le bus un bit dominant indiquant qu'une station plus prioritaire qu'elles, conserve l'accès au réseau.

Les techniques classiques pour réaliser le codage des bits sont les suivantes :
- le codage PWM (Pulse Width Modulation) dans lequel un bit est représenté par un créneau correspondant à la valeur du bit, précédé d'un créneau dominant et suivi d'un créneau récessif,
- le codage Manchester dans lequel un bit est représenté par un créneau correspondant à la valeur du bit, suivi d'un créneau de niveau inverse, et
- le codage NRZ (Non Retour à Zéro) dans lequel le bit correspond à la valeur d'un seul créneau.

Pour ce dernier codage, il est nécessaire d'assurer une synchronisation d'une station en réception en cas d'une succession de bits de même valeur.

Dans le cas de l'utilisation d'un codage NRZ simple, chaque octet transmis est précédé d'un niveau de début (start) dominant et suivi d'un niveau d'arrêt (stop) récessif.

Ce codage NRZ peut être complété par l'utilisation d'un bit de bourrage (bit Stuffing).

Dans ce cas, à la suite d'une série de n bits de niveau identique, on insère en émission un bit de valeur opposée dit bit de bourrage, pour créer une transition permettant la resynchronisation des stations.

Ce bit est supprimé lors de la réception.

Cette méthode de codage est la plus efficace en terme de rendement de codage et est celle utilisée dans le protocole CAN (Bosch).

Cependant cette méthode de codage est sensible aux erreurs, et une perturbation du réseau peut engendrer une désynchronisation d'un ou de plusieurs bits.

Si cette technique n'est pas utilisée, il est alors nécessaire d'admettre de diminuer en partie le rendement de codage pour gagner en robustesse.

En effet, le codage NRZ (start-stop) a un rendement de 80% dans la mesure où un octet de huit bits est codé sur dix bits. Ce rendement est acceptable mais les transitions permettant la resynchronisation des stations peuvent être espacées de neuf bits.

Il est possible d'améliorer cela en codant les informations sous forme de blocs de quatre bits en mots de cinq bits, pour un rendement équivalent, les messages comportant plus de transitions.

Par exemple, le réseau optique FDDI ( Fiber Distributed Data Interface) a retenu un tel type de codage par blocs.

Cependant, de façon à assurer une composante continue la plus faible possible, les mots de cinq bits sont tels qu'ils comportent soit deux "1" et trois "0", soit trois "1" et deux "0".

Le codage obtenu est bien adapté à une méthode d'accès par jeton ou par scrutation, mais est d'une mise en oeuvre extrêmement difficile pour une méthode d'arbitrage bit à bit.

En effet, le transcodage réalisé ne permet pas d'associer un bit émis et un bit codé.

Le but de l'invention est donc de résoudre les problèmes évoqués ci-dessus en proposant un procédé et un dispositif assurant l'association directe entre bit émis et bit codé, permettant la mise en oeuvre d'une stratégie d'accès au réseau par arbitrage bit à bit, avec une possibilité de prise en compte du rang du bit émis et qui soient d'une grande fiabilité.

A cet effet, l'invention a pour objet un procédé de transmission d'informations entre stations d'un réseau de communication, dont la méthode d'accès est l'arbitrage bit à bit, notamment pour véhicule automobile, caractérisé en ce qu'on code les informations sous forme de blocs de quatre bits en mots de cinq bits, trois bits de chaque bloc étant codés suivant le codage NRZ et un, suivant le codage Manchester.

Avantageusement, le bit codé en Manchester est le dernier bit du bloc.

Selon un autre aspect, l'invention a également pour objet un dispositif pour la mise en oeuvre du procédé décrit précédemment.

L'invention sera mieux comprise à l'aide de la description qui va suivre, donnée uniquement à titre d'exemple et faite en se référant aux dessins annexés, sur lesquels :
- la Fig.1 illustre une méthode de codage NRZ (non retour à zéro);
- la Fig.2 illustre une méthode de codage NRZ avec bit de bourrage;
- les Fig.3 et 4 représentent deux exemples de signaux perturbés dont la méthode de codage est le codage NRZ avec bit de bourrage;
- la Fig.5 illustre une méthode de codage par blocs;
- la Fig.6 illustre un premier mode de réalisation d'un procédé de codage selon l'invention;
- la Fig.7 illustre un message codé suivant le procédé de codage selon l'invention;
- les Fig.8,9 et 10 représentent des détails du message codé illustré sur la Fig.7; et
- la Fig.11 représente une partie d'un dispositif pour la mise en oeuvre d'un procédé selon l'invention.

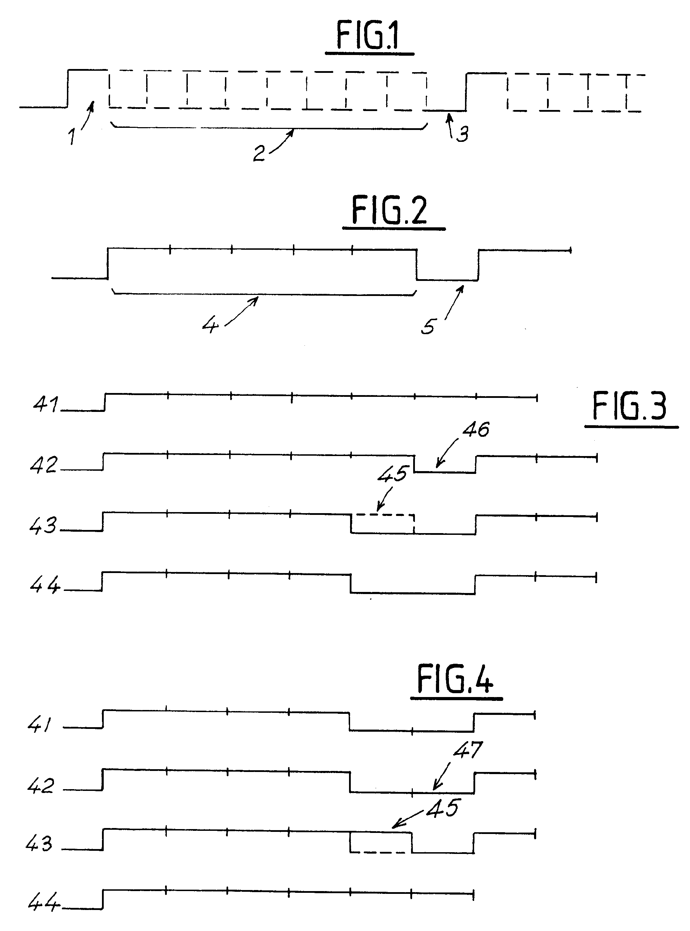

Ainsi qu'on l'a décrit précédemment, et comme cela est représenté sur la Fig.1, une méthode de codage NRZ (non retour à zéro) commence par l'émission d'un niveau de début (start) 1, dominant, suivi de l'octet à transmettre, cet octet étant désigné par 2 sur cette figure, et étant lui-même suivi d'un niveau d'arrêt (stop) récessif 3.

Un autre type de codage, représenté sur la Fig.2, consiste en un codage NRZ associé à un bit de bourrage.

A la suite d'une série de n bits de niveau identique 4, on insère en émission un bit de valeur opposée 5 à celle des bits déjà émis, ce bit étant appelé bit de bourrage, pour créer une transition permettant la resynchronisation des stations.

Ainsi que cela a été expliqué précédemment, ce bit est ensuite supprimé à la réception pour l'analyse.

La méthode de codage NRZ avec bit de bourrage est la plus efficace en terme de rendement de codage.

Cependant, cette méthode est extrêment sensible aux erreurs et une perturbation du réseau peut engendrer une désynchronisation d'un ou de plusieurs bits des stations.

Ainsi par exemple, sur les Fig.3 et 4, on a représenté des exemples de signaux perturbés dans lesquels le signal original à transmettre est indiqué en 41, le signal encodé suivant la technique de codage NRZ avec bit de bourrage et n=5 est illustré en 42, le signal perturbé est illustré en 43,le signal décodé par suppression du bit de bourrage est illustré en 44, tandis que le signal perturbé 43 comporte un bit erroné 45.

Dans le premier exemple, représenté sur la Fig.3, le bit de bourrage 46 a été reçu comme un bit normal et de ce fait la réception est en retard d'un bit.

Par contre, dans le second exemple représenté sur la Fig.4, un bit normal émis 47 a été reçu comme un bit de bourrage et de ce fait la réception est en avance d'un bit.

Ainsi qu'on l'a mentionné précédemment, il est possible de résoudre certains problèmes posés par le codage NRZ en codant les informations sous forme de blocs de quatre bits en mots de cinq bits afin d'obtenir un rendement équivalent au codage NRZ, mais dans lequel les signaux comportent plus de transitions.

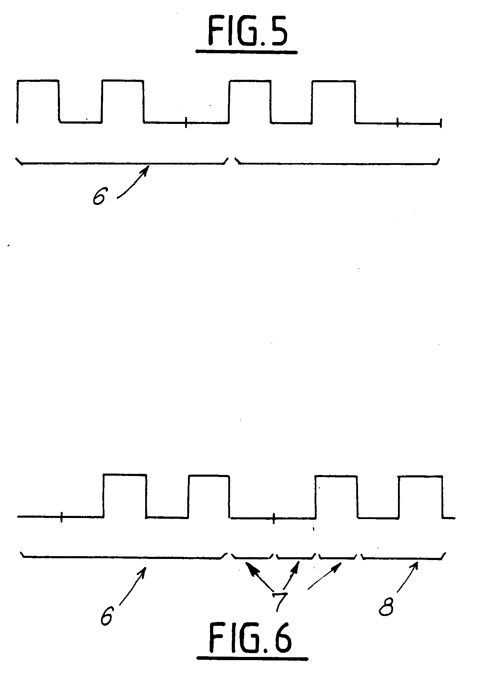

Comme cela est représenté sur la Fig.5, dans l'état de la technique,pour assurer une composante continue la plus faible possible, les mots de cinq bits sont tels qu'ils comportent soit deux "1" et trois "0", soit trois "1" et deux "0". Cette Fig.5 montre le codage de l'octet 22, 6, en héxadécimal.

Ainsi qu'on l'a mentionné précédemment, le codage obtenu est bien adapté à une méthode d'accès par jeton ou par scrutation, mais est d'une mise en oeuvre difficile pour une méthode d'arbitrage bit à bit dans la mesure ou le transcodage réalisé ne permet pas d'associer un bit émis et un bit codé.

Le procédé de transmission selon l'invention retient le concept du codage en blocs de quatre bits par mots de cinq bits, mais réalise une association directe entre un bit émis et un bit codé, permettant ainsi la mise en oeuvre d'une stratégie d'accès au réseau par arbitrage bit à bit, avec la possibilité d'une prise en compte du rang du bit émis.

Pour cela, et comme on peut le voir sur la Fig.6, on réalise le codage de chaque bloc en codant trois bits suivant le codage NRZ, ces trois bits étant illustrés par la référence 7 sur cette figure et un bit suivant le codage Manchester, comme indiqué en 8.

De ce fait, on assure l'association directe entre un bit émis et un bit codé. Cependant, le bit codé en Manchester est spécifiquement traité par la suite et d'une part comporte obligatoirement une transition garantissant une possibilité de resynchronisation des stations et d'autre part, il est mieux protégé contre les erreurs dans la mesure où une double erreur est nécessaire pour perturber deux créneaux successifs afin d'engendrer une erreur de bit non détectée.

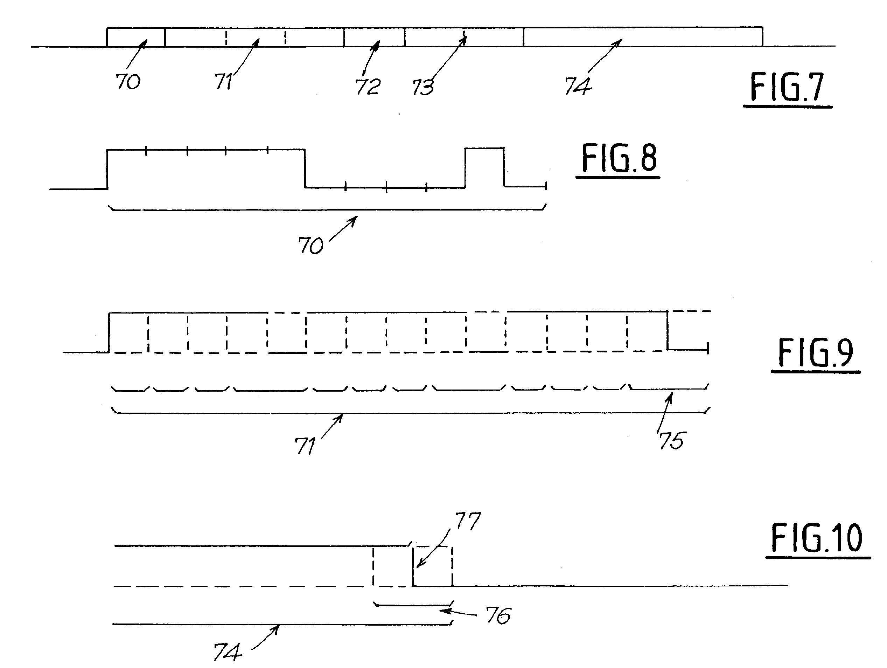

Pour tirer avantage de cette spécificité, on place le bit codé en Manchester de façon à sécuriser les bits les plus importants du message et à engendrer des transitions systématiques aux instants souhaités de la trame. Cela est obtenu en particulier dans l'exemple de message représenté sur la Fig.7 en codant systématiquement en Manchester, le dernier bit de chaque demi-octet.

Ainsi par exemple, une trame de message peut comporter (Fig.7) :
- un début de message 70 représenté plus en détail sur la Fig.8;
- une entête de message 71 de douze bits comportant comme dernier bit un bit de question-réponse qui, codé en Manchester, est plus particulièrement protégé;
- un demi-octet 72 donnant la taille des données transmises;
- des données 73 transmises par octet; et
- un code cyclique 74 de redondance sur 1 ou 2 octets dont le dernier bit codé en Manchester valide la fin du mes sage et assure une dernière transition systématique.

Sur la Fig.9 est représenté plus particulièrement l'entête de message de 12 bits, 71, comportant comme dernier bit, un bit de question-réponse 75 qui est codé en Manchester et qui comme on l'a indiqué précédemment, est plus particulièrement protégé.

Sur la Fig.10, le code de redondance sur 1 ou 2 octets comporte un dernier bit 76 codé en Manchester validant la fin du message et assurant une dernière transition systématique 77. Cette dernière référence de temps permet d'engendrer le temps nécessaire à un accusé de réception ou le temps séparant deux trames de message.

Le dispositif pour la mise en oeuvre d'un procédé tel que décrit précédemment est caractérisé en ce qu'au moins une partie des stations du réseau comporte des moyens de réception et d'émission d'informations muni d'un codeur-décodeur capable d'effectuer du codage et du décodage suivant le procédé NRZ et suivant le procédé Manchester, le fonctionnement de ce codeur-décodeur étant commuté en fonction du comptage des bits d'un signal émis ou reçu par la station après l'émission ou la réception d'un troisième bit.

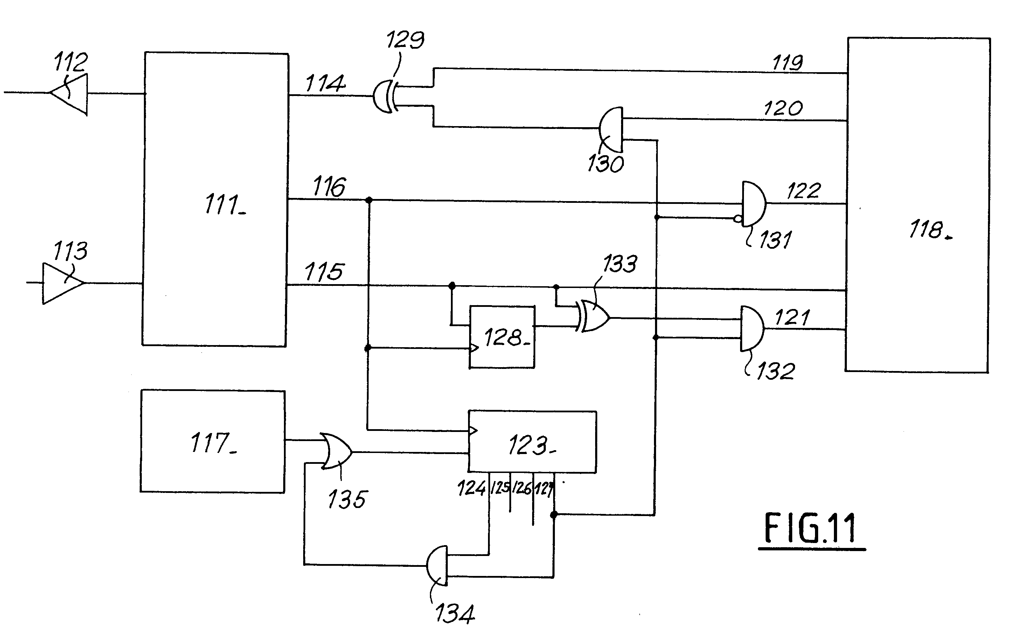

Ces moyens sont représentés sur la Fig.11 et comportent un bloc d'émission-réception 111 de créneau, encore appelé bit physique. Ce bloc est relié au bus du réseau de transmission d'informations du véhicule à travers un tampon d'émission 112 et un tampon de réception 113.

Ce bloc reçoit en entrée les bits physiques à émettre, par une liaison 114, et émet en sortie le bit physique reçu, par une liaison 115. Sur une sortie 116 de ce bloc est émise une horloge de bit physique par autosynchronisation sur la ligne. Un bloc logique 117 associé effectue l'émission et la réception du début de message, tandis qu'un bloc bit logique 118 représente l'interface avec des couches de communication supérieures de la station.

Ce bloc 118 émet un signal bit logique 119 et une demande de viol de code 120. Il reçoit le signal bit logique reçu en 115 et la détection de viol de code en 121. L'horloge de bit est fournie en 122.

Ces moyens comportent également un compteur 123 dont les sorties sont référencées respectivement en 124, 125, 126 et 127 et représentent respectivement les sorties de poids 1, 2, 4 et 8 de ce compteur.

Une bascule 128 permet de mémoriser le dernier bit physique reçu.

Ces moyens comportent également un certain nombre de portes 129, 130, 131, 132,133, 134 et 135 dont le fonctionnement sera décrit plus en détail par la suite et assurant les liaisons entre les différents organes décrits précédemment.

Après le début d'un message, le détecteur de début de message 117 initialise le compteur de bit physique 123 à zéro. Ce compteur s'incrémente et les quatre premières impulsions d'horloge du signal 116 assurent un fonctionnement transparent des moyens de codage-décodage suivant le codage NRZ.

A la cinquième impulsion de ce signal d'horloge 116,le codage 4 du compteur 123 est décodé par la montée à "1" de la sortie 127 de poids 4 de celui-ci qui fournit alors un signal indiquant le codage Manchester.

Ce signal, en émission, sauf s'il est inhibé par la porte ET 130 du fait du signal 120, inverse le niveau du bit logique émis en 119 de façon à engendrer un niveau inverse en 114.

En réception, ce signal autorise en 121 , à travers la porte 132, le résultat de la comparaison à la sortie de la porte 133, entre le bit physique en cours 115 et le bit physique présent mémorisé par la bascule 128, vérifiant ainsi qu'une transition s'est effectuée au cours du bit Manchester.

Enfin, ce signal inhibe la cinquième impulsion d'horloge physique 116 par la porte ET 131 de façon à ne laisser passer que quatre impulsions d'horloge bit logique.

L'impulsion d'horloge suivante incrémente le compteur 123 à la valeur 5 qui décodée par la porte ET 134 reliée aux sorties 124 et 127 de ce compteur, réinitialise à zéro ce compteur à travers la porte 135 en association avec le signal de sortie du bloc 117, la sortie de la porte 135 étant reliée à une entrée de réinitialisation du compteur 123.

La réalisation de ce codeur-décodeur présente donc une structure équivalente à celle d'un codeur-décodeur suivant le procédé de codage Manchester ou suivant le procédé de codage NRZ avec bit de bourrage et il peut donc être implémenter facilement dans des circuits de communication utilisant un protocole de communication avec méthode d'accès par arbitrage bit à bit avec une trame organisée en octets.

## Revendications

1. Procédé de transmission d'informations entre stations d'un réseau de communication dont la méthode d'accès est l'arbitrage bit à bit, notamment pour véhicule automobile, caractérisé en ce qu'on code les informations sous forme de blocs de quatre bits en mots de cinq bits, trois bits (7) de chaque bloc étant codés suivant le codage NRZ et un (8), suivant le codage Manchester.

2. Procédé selon la revendication 1, caractérisé en ce que le bit (8) codé en Manchester est le dernier bit du bloc.

3. Dispositif de transmission d'informations entre stations d'un réseau de communication dont la méthode d'accès est l'arbitrage bit à bit, notamment pour véhicule automobile, pour la mise en oeuvre du procédé selon la revendication 1 ou 2, caractérisé en ce qu'au moins une partie des stations du réseau comporte des moyens d'émission et de réception d'informations munis d'un codeur-décodeur capable d'effectuer du codage et du décodage suivant le procédé NRZ et le procédé Manchester, des moyens de comptage (123) du nombre de bits d'un signal d'informations reçu ou émis par une station considérée suivant le codage NRZ et des moyens de commutation du fonctionnement des moyens d'émission ou de réception de cette station en codage/décodage suivant le procédé Manchester après l'émission ou la réception d'un troisième bit.

## Patentansprüche

1. Verfahren zur Informationsübertragung zwischen Stationen eines Kommunikationsnetzwerkes, dessen Zugriffsmethode die Entscheidung Bit für Bit ist, insbesondere für Kraftfahrzeuge, dadurch gekennzeichnet, daß man die Informationen in Form von Blöcken aus vier Bits in Wörtern von fünf Bits codiert, wobei drei Bits (7) jedes Blocks nach der NRZ-Codierung und eines (8) nach der Manchester-Codierung codiert werden.

2. Verfahren nach Anspruch 1, dadurch gekennzeichnet, daß das nach Manchester codierte Bit (8) das letzte Bit des Blockes ist.

3. Vorrichtung zur Informationsübertragung zwischen Stationen eines Kommunikationsnetzwerkes, dessen Zugriffsmethode die Entscheidung Bit für Bit ist, insbesondere für Kraftfahrzeuge, zum Durchführen des Verfahrens nach Anspruch 1 oder 2, dadurch gekennzeichnet, daß wenigstens ein Teil der Stationen des Kommunikationsnetzwerkes Einrichtungen zum Senden und zum Empfangen von Informationen, welche mit einer Codier-Decodiervorrichtung versehen sind, die die Codierung und die Decodierung nach dem NRZ-Verfahren und dem Manchester-Verfahren durchführen kann, Zähleinrichtungen (123) für die Anzahl der Bits eines Signales aus Informationen, die von einer betrachteten Station nach der NRZ-Codierung empfangen oder ausgesendet worden sind, und Umschalteinrichtungen für den Betrieb der Einrichtungen zum Senden oder zum Empfangen dieser Station in Codierung/Decodierung nach dem Manchester-Verfahren nach dem Senden oder dem Empfangen eines dritten Bits umfaßt.

## Claims

1. Method of transmitting information between stations of a communication network of which the access method is bit-by-bit arbitration, in particular for motor vehicles, characterised in that the information is encoded in the form of blocks of four bits in five-bit words, three bits (7) of each block being encoded according to the NRZ encoding method and one (8) according to the Manchester encoding method.

2. Method according to Claim 1, characterised in that the bit (8) encoded in Manchester code is the last bit of the block.

3. Device for transmitting data between stations of a communication network of which the access method is bit-by-bit arbitration, in particular for motor vehicles, for implementing the method according to Claims 1 or 2, characterised in that at least some of the stations of the network include means of transmitting and receiving information and are equipped with an encoder/decoder capable of performing encoding and decoding according to the NRZ method and the Manchester method, means of counting (123) the number of bits in a data signal received or transmitted by a given station using the NRZ encoding method and means of switching the means of transmission or reception of this station to encoding/decoding using the Manchester method after the transmission or reception of a third bit.
